# EUROPÄISCHE PATENTSCHRIFT

(11) **EP 1 751 860 B1**
(45) Veröffentlichungstag und Bekanntmachung des Hinweises auf die Patenterteilung: **09.05.2012**
(21) Anmeldenummer: 05726506.8
(22) Anmeldetag: 09.04.2005
(51) Int. Cl.: H03K 3/53, A23L 1/025

(54) **EINRICHTUNG ZUM ELEKTROPORIEREN VON BIOLOGISCH PFLANZLICHEM PROZESSGUT**
DEVICE FOR THE ELECTROPORATION OF BIOLOGICALLY VEGETABLE PROCESSING MATERIAL
DISPOSITIF D'ELECTROPORATION D'UNE MATIERE DE PROCEDE BIOVEGETALE

(30) Priorität: 18.05.2004 DE 102004025046
(43) Veröffentlichungstag der Anmeldung: 14.02.2007
(73) Patentinhaber: Karlsruher Institut für Technologie, 76131 Karlsruhe (DE)
(72) Erfinder: SACK, Martin, 76287 Rheinstetten (DE); SCHULTHEISS, Christoph, 76327 Berghausen (DE)
(86) Internationale Anmeldenummer: PCT/EP2005/003749
(87) Internationale Veröffentlichungsnummer: WO 2005/117257

(56) Entgegenhaltungen:
- DE-C1- 10 144 486
- SCHULTHEISS C ET AL: "Development of an industrial electroporation device" CONFERENCE RECORD OF THE 25TH INTERNATIONAL POWER MODULATOR SYMPOSIUM AND 2002 HIGH-VOLTAGE WORKSHOP. HOLLYWOOD, CA, JUNE 30 - JULY 3, 2002, INTERNATIONAL POWER MODULATOR SYMPOSIUM, NEW YORK, NY : IEEE, US, 30. Juni 2002 (2002-06-30), Seiten 563-566, XP010636711 ISBN: 0-7803-7540-8
- SCHULTHEISS, C: "Processing of Sugar Beets With Pulsed-Electric Fields" IEEE TRANSACTIONS ON PLASMA SCIENCE, Bd. 30, Nr. 4, 1. August 2002 (2002-08-01), Seiten 1547-1551, XP002339732 USIEEE INC. NEW YORK.

## Beschreibung

Die Erfindung betrifft eine Einrichtung zum Elektroporieren von in eine Prozessflüssigkeit getauchten Früchten, Beeren, Rüben, Wurzeln. Diese biologisch pflanzlichen Produkte werden hier als Prozessgut bezeichnet. Die Einrichtung besteht aus einem Reaktorraum mit zwei sich darin gegenüberstehenden Elektrodengruppen, die an den Ausgang einer elektrischen, pulsförmig entladbaren Energiequelle angeschlossen sind, um im Reaktorraum zwischen den beiden Elektrodengruppen gepulste elektrische Felder zu erzeugen. Dabei wird vorübergehend jeweils eine Feldstärke derart erreicht, dass die biologischen Zellen des Prozessguts, das einem solchen gepulsten elektrischen Feld mindestens einmal ausgesetzt wird, irreversibel geöffnet werden. Dieser Vorgang der Porenerzeugung an biologischem Zellmaterial wird als Elektroporation bezeichnet, bzw. eine solche Zelle wird elektroporiert. Bei großen Massenströmen ist das ein energiesparender Zellaufschluss dieses biologischen Prozessguts.

Zur Elektroporation solcher großer, industriell zu verarbeitender Massenströme ist einerseits ein ausreichend großer Förderquerschnitt erforderlich, andererseits muss auf einer bestimmten Länge längs der Förderrichtung eine für die Elektroporation ausreichend große Feldstärke über das dortige gesamte Volumen gewährleistet sein. Für große Förderquerschnitte sind hierfür vergleichsweise große Elektrodenoberflächen notwendig, die einen hohen elektrischen Strom mit sich bringen, der nicht unbedingt wirtschaftlich aus einem Marx-Generator aufgebracht werden kann. Aus Sicherheitsgründen müssen Einlass und Auslass des Prozessguts in genügend großer Entfernung vom Elektroporationsbereich auf Massepotential liegen.

Bei der monopolaren Bepulsung (z.B. Schultheiss : "Development of an industrial electroporation device", conference record of the 25th international power modulator symposium, IEEE, 2002) führt ein Leckstrom zu den Erdelektroden unter der Wasseroberfläche zu erhöhten Verlusten. Bisher werden kleine kreisförmige Elektroden mit stark inhomogenem Feld eingesetzt, die aus freilaufenden Marxgeneratoren bepulst wurden. Durch das inhomogene Feld wird die für die Elektroporation nötige Mindestfeldstärke nicht über den gesamten notwendigen Temperaturbereich in allen Reaktorbereichen erreicht. Infolge der runden Elektrodengeometrie und der nicht synchronen Bepulsung entstehen erhöhte Randfeldverluste. Die Bepulsung des Prozessguts in einem homogenen Feld ist Stand der Technik, wird aber bisher bei weitaus geringerer Spannung und damit E-Feldstärke und mit zeitlich längeren Impulsen durchgeführt.

Der in einer gesellschaftseigenen, prototypischen Anlage "Mobile KEA" angewandte isolierte Betrieb des Marxgenerators besitzt den Nachteil, dass infolge von Unsymmetrien des Elektroporationsprozessguts die Teilspannungen an den beiden Ausgängen gegenüber Masse höhere Werte als die halbe Ausgangsspannung annehmen können. Die Isolation ist somit für mehr als die halbe Generatorspannung auszulegen, im ungünstigsten Fall für die volle Generatorspannung. Beim mittig geerdeten Marx-Generator kann die Strommesssonde vorteilhaft nahe dieser Erdung eingebaut werden und muss dann nur für eine vergleichsweise geringe Spannung isoliert werden. Bei schwankendem Mittenpotential wie beim isoliert betriebenen Generator muss ein erhöhter Isolationsaufwand für die Strommesssonde betrieben werden.

Der Erfindung liegt die Aufgabe zugrunde, ein in weiten Bereichen homogenes repetierend gepulstes elektrisches Feld hoher Feldstärke und kurzer Pulsdauer in einem leitfähigen Medium für die industrielle Elektroporation großer Massenströme in einem entsprechend großen Volumen energieeffizient und betriebssicher bereit zu stellen.

Die Aufgabe wird durch eine Einrichtung zum Elektroporieren mit den kennzeichnenden Merkmalen des Anspruchs 1 gelöst. Die Energiequelle der Einrichtung ist elektrisch bipolar aufgebaut. Sie besteht aus mindestens einem bipolaren Hochspannungspulsgenerator mit zwei Hochspannungsausgängen, die je eine der beiden Elektrodengruppen kontaktiert. Im Falle mehrerer bipolarer Hochspannungspulsgeneratoren sind dieselben baugleich. Und mindestens im Fall von zwei aber auch von mehr als zweien Hochspannungspulsgeneratoren sind dieselben jeweils mit einer Triggereinrichtung versehen, um sie zur vorgegebenen Zeit gleichzeitig zu zünden. Bei nur einem Hochspannungspulsgenerator kann die Triggereinrichtung entfallen, wenn die Funkenstrecken des Pulsgenerators im Selbstdurchbruch gefahren werden. Soll bei hinreichender Ladespannung zeitbestimmt auch der eine Pulsgenerator gezündet werden, ist dazu die Triggereinrichtung auch dann nötig.

Die beiden Elektrodengruppen bestehen aus jeweils mindestens einer Teilelektrode. Es gibt also mindestens ein Teilelektrodenpaar, zwischen der das zur der Elektroporation notwendige gepulste elektrische Feld aufgebaut werden kann. Dabei ist eine Teilelektrode nur an einen Hochspannungsausgang und nie an mehrere Hochspannungsausgänge angeschlossen. Umgekehrt, ist ein Hochspannungsausgang an mindestens eine Teilelektrode angeschlossen. Wichtig für das vorgesehene Arbeiten der Elektroporationseinrichtung ist, dass der an den Ausgang eines Hochspannungspulsgenerators angeschlossene Lastkreis in seiner komplexen Impedanz dem an einen andern Hochspannungspulsgenerators der Energiequelle angeschlossenen Lastkreis gleich ist. D.H. dass die Induktivitäten sowie die ohmschen Widerstände einschließlich der Anteile des Prozessguts in allen Teil-Stromkreisen nahezu gleich sind, so dass sich gleiche Kurvenverläufe ergeben. Hiermit kann bei der Entladung die gegenseitige Entkopplung der Pulsgeneratoren eingehalten werden. Die mindestens zwei Hochspannungspulsgeneratoren der Energiequelle sind während der Entladung durch die durch die Prozessflüssigkeit zwischen den Teilelektroden gebildeten elektrolytischen Widerstände voneinander entkoppelt. Der Elektrolyt ist die Prozessflüssigkeit samt eventuellen Lösungsanteilen in der das Prozessgut darin geströmt wird. Bei einer gut eingestellten Einrichtung überwiegt der induktive Anteil der Teil-Stromkreisimpedanzen den ohmschen Anteil, so dass dadurch der Einfluss resistiver Inhomogenitäten im Innern des Elektroporationsraums auf den Kurvenverlauf reduziert wird.

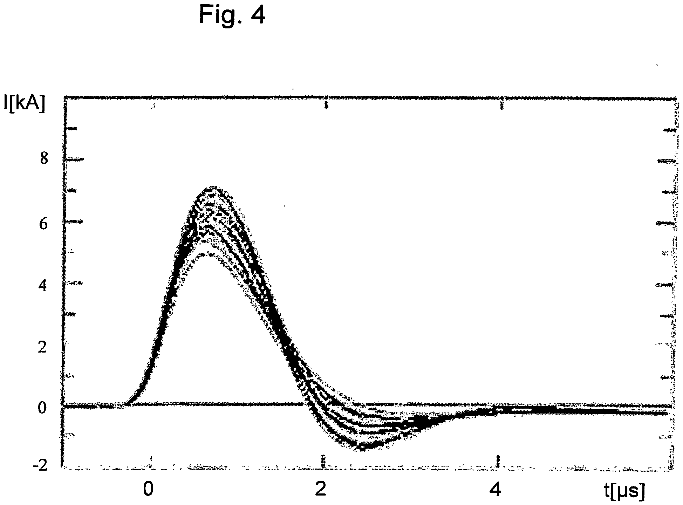

Durch die komplexe Impedanz des Entladekreises ist der Verlauf der Spannung zwischen den beiden Elektrodengruppen, bzw. der Strom durch das Prozessgut festgelegt - RLC-Kreis-Entladung (als Beispiel siehe Figur 4). Prinzipiell legen Real- und Imaginäranteil der komplexen Impedanz den Verlauf fest, er kann bei von null verschiedenem R und abhängig davon von schwach gedämpft schwingend über aperiodisch gedämpft bis stark gedämpft verlaufen. Häufig werden solche Einrichtungen zur Elektroporation stark gedämpft schwingend bis aperiodisch gedämpft betrieben, weil nur die erste Halbschwingung der Entladung als elektrische Feldpulserzeugung für den Prozess von Bedeutung, bzw. maßgebend ist. Anstieg und Amplitude des Pulses sind dadurch einstellbar. Zur Schonung der Kondensatoren des Marx-Generators wird aber unter Umständen auch der aperiodisch bis stark gedämpfte Entladeverlauf in Betracht gezogen.

In den Unteransprüchen 2 bis 10 sind Ausgestaltungen an der Einrichtung beschrieben, die die Elektroporation vorteilhaft ablaufen lassen.

So ist/sind der/die Hochspannungspulsgenerator/en der Energiequelle ein n-stufige/r Marx-Generator/en. Typisch für einen Marx-Generator ist die parallele Aufladung seiner Stufen und die Reihenschaltung und damit die Spannungsaddition dieser bei der Entladung. Daher ist die Stufenzahl n bei einem Marx-Generator >= 2, insbesondere in Hinblick auf die elektrische Bipolarität der Einrichtung, da das Bezugspotential bei Zwangsanbindung zwischen den Stufen eingerichtet wird oder im floatenden Fall sich dazwischen einstellt. Der jeweilige Generatoranfang und das jeweilige Generatorende eines Marx-Generators hat zwei verschiedene Hochspannungspotentialausgänge, an die mindestens ein Teilelektrodenpaar angeschlossen ist (Anspruch 2). Die Marx-Generatoren sind gleichartig an ein Bezugspotential angeschlossen. Das ist häufig Erdpotential, kann aber auch davon verschieden sein, sofern es technisch begründet ist (Anspruch 3). Wie in Anspruch 4 zum Ausdruck gebracht, ist das Bezugspotential durch Anbinden nicht zwingend, es kann schweben, im technischen Sprachgebrauch auch floaten genannt. Das Massepotential stellt sich dann zwischen den beiden Elektrodengruppen im Reaktorraum geometrie- und elektrolytbestimmt selbsttätig ein.

In einem Strömungskanal für das Prozessgut stehen sich die Elektrodengruppen ortsfest (Anspruch 5) gegenüber oder bewegen sich relativ zueinander (Anspruch 6). Im letzteren Fall bewegen sich beide Elektrodengruppen oder nur eine davon. Das ist beispielsweise der Fall, wenn Transportrechen oder -trommeln als Baukomponenten einer solchen Einrichtung ausgewählt wurden. Die Teilelektroden sind blank in den Reaktorraum exponiert und die fest eingebauten Teilelektroden einer Gruppe in der Reaktorwand versenkt oder bündig eingebaut oder stehen erhaben im Reaktorraum.

Eine spezielle Ausgestaltung der Einrichtung wird in Anspruch 7 beschrieben. Demnach besteht die Einrichtung zur Elektroporation aus dem Reaktorraum in Form einer Wanne. Dort stehen sich zwei Wannenwänden gegenüber, zwischen denen das in die Prozessflüssigkeit getauchte Prozessgut durchströmt. Die eine Wannenwand davon ist mit einer Gruppe u-förmigen Teilelektroden und die andere davon ebenfalls mit einer Gruppe gleichartiger Teilelektroden gleicher Anzahl bestückt. Die Teilelektroden bezüglich der Mittenebene zwischen diesen beiden Wänden stehen sich spiegelbildlich mit offenem U gegenüber und folgen in dieser paarweisen Anordnung in Strömungsrichtung aufeinander. Zumindest der innere Bereich jeden U's liegt blank in der durchströmenden Prozessflüssigkeit. In der diese beiden Wannenwände verbindenden Wannenwand sind zwei Gruppen an gleichartigen Teilelektroden eingelassen. Sie sind stab- oder bandförmig. Diese beiden Gruppen stehen bezüglich der oben erklärten Mittenebene spiegelbildlich zueinander. Immer eine Teilelektrode der einen Gruppe fluchtet mit der der spiegelbildlichen aus der andern Gruppe, ohne sich zu berühren. Die in das Wanneninnere exponierten Flächen dieser Elektroden liegen blank in der durchströmenden Prozessflüssigkeit. Diese stab- oder bandförmigen Elektroden folgen ebenfalls paarweise in Strömungsrichtung aufeinander.

Die u-förmigen Teilelektroden und die stab- oder bandförmigen Teilelektroden auf der einen Seite der Mittenebene sind über mindestens einen bipolaren Hochspannungspulsgenerator miteinander verbunden. Die u-förmigen Teilelektroden und die stab- oder bandförmigen Teilelektroden auf der andern Seite der Mittenebene sind gleichartig an mindestens einen solchen Hochspannungspulsgenerator angeschlossen.

Eine leitersprossenartige Anordnung elektrisch leitender Stäbe, die miteinander elektrisch nichtleitend gekoppelt sind, bewegt sich derart mit den jeweiligen beiden Stabenden durch die spiegelbildlich zueinander sitzenden u-förmigen Teilelektroden, dass die Längsachse der Stäbe stets senkrecht die Mittenebene durchdringen.

Die leitersprossenartige Anordnung mit den u-förmigen Elektroden durch den oder die momentan durch ein u-förmiges Elektrodenpaar laufenden Stab oder Stäbe ist durch das Prozessgut in der Prozessflüssigkeit elektrolytisch gekoppelt, die stab- oder bandförmigen Elektroden ebenso, so dass sich zwischen diesem Stab oder diesen Stäben und den stab- oder bandförmigen Elektroden während der Entladung des elektrischen Energiespeichers das zur Elektroporation notwendige pulsförmige elektrische Feld ausbildet. Durch die Anzahl an und die Dimensionierung der u-förmigen Elektroden kann der Verlauf des elektrischen Feldes hinsichtlich seiner Homogenität/Inhomogenität entscheidend geprägt werden. Es kann sich nämlich vorübergehend immer nur ein Stab aus der leitersprossenförmigen Stabanordnung zwischen zwei zueinander spiegelbildlichen, u-förmigen Elektroden befinden oder mehr als einer, je nach eingestellter Abstandsfolge der Stäbe bzw. Abstandsfolge und jeweilige Länge der u-förmigen Elektroden. Letztere folgen in beiden Gruppen gleichartig aufgestellt aufeinander. Eine Ebene könnte zwischen den Schenkeln dieser u-förmigen Elektroden durchgezogen werden.

Ist die leitersprossenartige Stabanordnung wie nach Anspruch 8 kreisbandförmig geschlossen. Kann der Reaktionsraum trommelförmig aufgebaut werden. Ist die leitersprossenartige Stabanordnung in der Art eines über zwei Rollen umlaufenden Bandes zusammengefasst, kann der Reaktionsraum wannenförmig flach sein (Anspruch 9).

Zur räumlichen Begrenzung des pulsförmigen elektrischen Feldes sitzt von der Strömung des Prozessguts her gesehen, vor dem Eintritt in den Bereich der beiden Elektrodengruppen und nach dem Austritt daraus je ein weiteres Elektrodenpaar, das mit einem Bezugspotential wie Masse verbunden ist (Anspruch 10). Insbesondere wird so bei resistiven Inhomogenitäten im Innern des Elektroporationsraums einer Potentialverschleppung entgegenwirkt. Diese Maßnahme dient vornehmlich der Anlagensicherheit.

Mit einer solchen Einrichtung ist ein breiter Homogenfeldbereich einstellbar, das bedeutet geringerer Energieverlust im Randfeldbereich als bei einzeln bepulsten punktförmigen Elektroden. Die Aufteilung der Elektroden und die simultane Bepulsung aus mehreren Hochspannungspulsgeneratoren/Marxgeneratoren bedeutet geringerer Strom pro Marxgenerator als bei Bepulsung aus nur einem Marxgenerator, d. h. längere Komponentenstandzeit, insbesondere der Funkenstrecken, und modulare Erweiterbarkeit der Anlage aufbauend auf einer erprobten Konstruktion (siehe Anspruch 7 beispielsweise). Ein bipolarer Betrieb bedeutet idealerweise kein Stromabfluss zu den Masseelektroden, d.h. geringere Verluste, Wasseroberflächen eintrags- und austragsseitig sind idealerweise spannungsfrei. Im Sonderfall der symmetrischen Bipolarität hat man gegenüber Erdpotential als speziellem Bezugspotential halbierte Spannung gegenüber Erde verglichen mit monopolarem Betrieb. Technisch bedeutet das geringeren Isolationsaufwand. Statt druckgasteilisolierter Leitung für 300 kV können handelsübliche E-lektrofilterkabel für 150 kV eingebaut werden.

Mit der Einrichtung lassen sich alle bisher bekannten Reaktorgeometrien mit monopolaren elektrischen Energiequellen mit deutlich reduziertem elektrischem Isolationsaufwand realisieren. Die Reaktorquerschnittsgeometrie rund oder polygonal ist einsetzbar, und deshalb kann strömungstechnischen Forderungen leicht nachgekommen werden. Polygonale Reaktorquerschnitte ab rechteckig, üblicherweise quadratisch, sind gängig. Vorzugsweise ist die Polygonalität geradzahlig, um senkrechtes Gegenüberstehen der beiden felderzeugenden Elektrodengruppen einrichten zu können.

An Hand der Zeichnung wird im Folgenden die Potentiallinienausbildung zwischen den beiden Elektrodengruppen erläutert und dann beispielsweise für eine geplante, bipolare Elektroporationseinrichtung für die Zuckerrübenprozessierung in ihrer feldbildenden Elektrodenanordnung beschrieben. Die Figuren zeigen:
- Figur 1: die 2D-Simulationeiner Plattenelektrodenanordnung,
- Figur 2: u-förmige Stromübertrager auf durchlaufende Stangen,
- Figur 3: 2D-Simulation an der Wannenunterseite,
- Figur 4: gemessene Stromverläufe.

Obwohl elektrisch ein asymmetrisch bipolarer Aufbau grundsätzlich möglich ist, wird jetzt der symmetrisch bipolare Aufbau erläutert. Der elektrische Energiespeicher besteht aus mindestens einem Hochspannungspulsgenerator in Form eines mehrstufigen Marx-Generators.

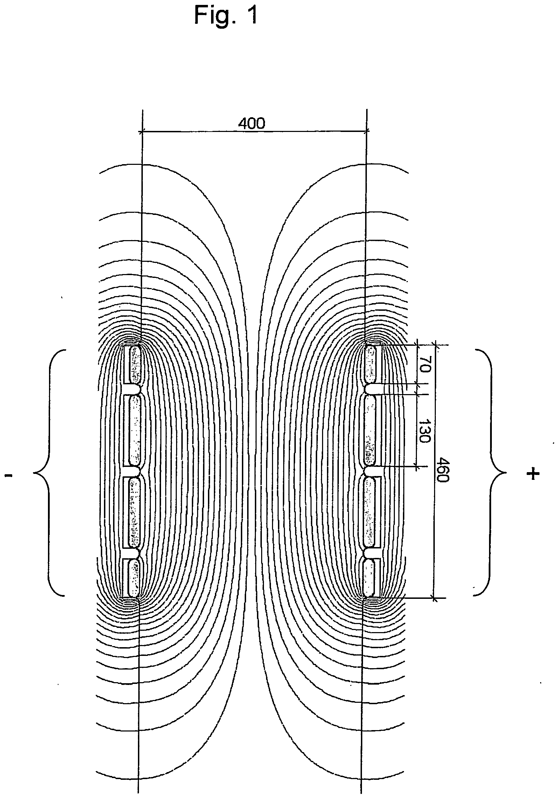

Die einander gegenüberliegenden, felderzeugenden Elektrodengruppen der Einrichtung zur Elektroporation werden gleichzeitig mit betragsmäßig gleicher Spannung unterschiedlicher Polarität beaufschlagt. Wie das Äquipotentiallinienbild in Figur 1 verdeutlicht, baut sich die Spannung von den Elektroden zur Mitte des Reaktors hin und seitlich in Richtung Ein- und Austragsöffnungen ab. Bei idealer elektrischer Symmetrie stellt sich nach dem Prinzip des Spannungsteilers in der Reaktormitte und insbesondere an den Ein- und Austragsöffnungen selbstständig Massepotential ein.

Figur 1 zeigt die 2D-Simulation der beispielhaften PlattenelektrodenAnordnung. Die eingetragenen Maße sind in mm. Zwischen den beiden Elektrodengruppen, links im Bild die negativ beaufschlagte und rechts im Bild die positivbeaufschlagte Elektrodengruppe, und nahe um sie ist das Äquipotentiallinienbild eingezeichnet. Die beiden Elektrodengruppe stehen im Abstand von 400 mm einander gegenüber. Die Elektrodenbreiten sind so gewählt, dass sich für jede Elektrode der gleicher Widerstand bzw. Strom ergibt. Im simulierten Fall ergibt sich für eine Flüssigkeitsleitfähigkeit von 1,5 mS/cm ca. 33 Ohm pro halbem Meter Elektrodenlänge in der Zeichenebene. In Zeichenebene sind mehrere Teilelektroden aneinandergesetzt, um bei gegebenem Teilwiderstand eine größere Breite zu bepulsen. Wird statt einer Verbreiterung die gleiche Anzahl an Elektroden in Förderrichtung hintereinander geschaltet, erhöht sich der Wirkungsgrad gegenüber dem Fall der Reaktorverbreiterung, da sich das Verhältnis von Homogenfeldbereich zu Randfeldbereich verbessert.

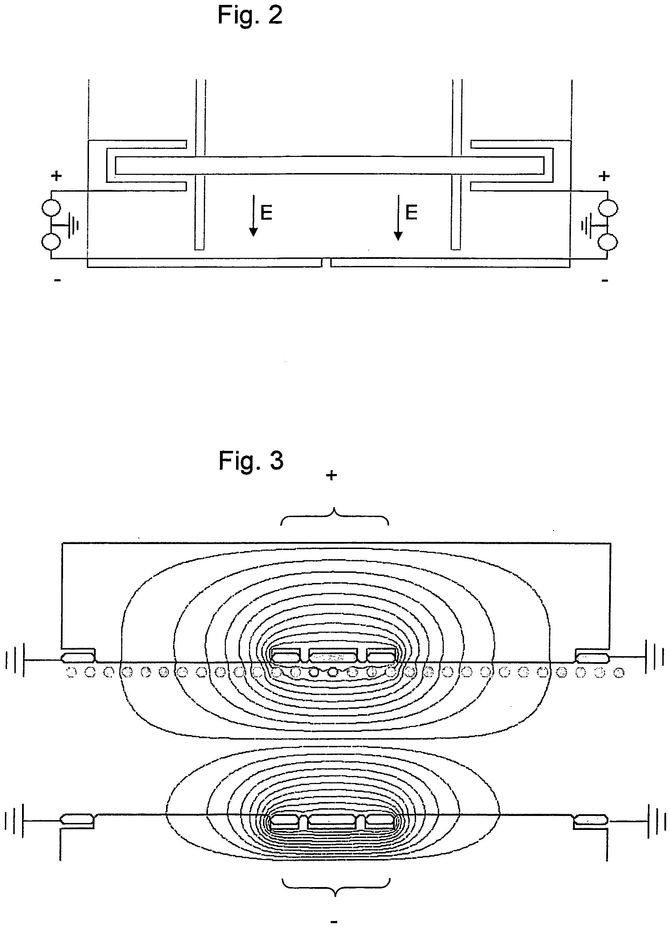

Als maßgebliche Elemente des Spannungsteilers wirken die Teilwiderstände im Fördergut sowie die Induktivitäten der Zuleitungen und Marx-Generatoren. Eine PSPICE-Simulation zeigt, dass der induktive Anteil eine Versteuerung des ohmschen Anteils durch das Fördergut abmildert. Voraussetzung für eine gute Spannungsaufteilung sind gleiche Induktivitäten in beiden Zuleitungszweigen, dem mit positivem und dem mit negativem Potential. Das wird entweder durch einen streng symmetrischen Aufbau oder eine Ausgleichsinduktivität erreicht, die vorteilhafter Weise masseseitig nahe der Generatormittenerdung angebracht ist. Die sicherheitshalber ein- und austragsseitig eingebauten Masseelektroden sind idealer Weise stromlos (siehe Figur 3). Sie haben eine Schutzfunktion im Falle von Unsymmetrien des Förderguts, die sich nicht vollständig vermeiden lassen. Durch den bipolaren Betrieb wird ferner die Spannungszuführung zu den Elektroden für eine reduzierte Spannung ausgelegt.

Bei der Elektroporationsanlage für Zuckerrüben erfolgt die Förderung mittels eines mitnehmerbestückten Förderrades (siehe den Fördertrommelausschnitt mit dem Prozessraumbereich in Figur 2). Aufgrund verfahrenstechnischer Gegebenheiten (Rübenförderung) ergibt sich der geringste Begrenzungsabstand des Elektroporationsraums von 30 cm für die geplante Anlage zwischen Förderrad und Wannenboden. Dementsprechend müssen die Elektroden in der Bodenwanne und auf den Förderrad aufgebracht werden. Das Förderrad wird mit elektrisch leitenden Stangen belegt, die nahezu die gesamte Reaktorbreite überspannen. Die Stangen haben einen Durchmesser von ca. 1-2 cm, ihr Abstand zueinander liegt ebenfalls zwischen ca. 1-2 cm. Im Elektroporationsbereich werden die Stangen mittels flach oder u-förmig ausgeführten Elektroden, dem Stromübertragerpaar, elektrolytisch mit der Spannungsquelle verbunden. Durch dieses u-förmige Stromübertragerpaar, dessen beide Elektroden sich bezüglich der Mittenebene mit der Öffnung spiegelbildlich gegenüber stehen, läuft die Stange, die durch zwei von einer Drehachse (hier nicht sichtbar, ist oberhalb der dargestellten Figur 2) radial ausgehenden Stäben elektrisch nicht leitend gehalten wird, und hat elektrolytischen Kontakt mit diesen. (siehe Skizze Bild 2). Dem in der Figur 2 sichtbaren Stromübertragerpaar und der momentan durch sie laufenden Stange liegen die beiden zueinander fluchtenden, schmalen plattenförmigen Elektroden im Wannenboden gegenüber, die sich nicht unmittelbar elektrisch leitend berühren. Die an der linken Seitenwand sitzende u-förmige Elektrode und die darunter liegende bandförmige, in die Mitte des Reaktorraumes horizontal ragende Elektrode sind an den mittig geerdeten, stilisierten Marx-Generator bipolar angeschlossen. Rechts im Bild die beiden gleichen Elektroden ebenso an den zugeordneten baugleichen Marx-Generator. Bei der zeitgleichen Entladung der beiden Marx-Generatoren bildet sich zwischen der durch die beiden U-Elektroden laufende und damit dort elektrolytisch koppelnde Stange und den beiden darunter liegenden beiden bandförmigen, fluchtenden Elektroden das für die Elektroporation notwendige elektrische Feld E aus. Gleichzeitig sind beide Marx-Generatoren über die widerstandsbehaftete elektrolytische Kopplung der Elektroden mit der Stange und der beiden sich berührungslos gegenüberstehenden Elektroden im Prozessraumboden voneinander entkoppelt.

Die 2D-Simulation in Figur 3 zeigt die beispielhafte Elektrodenanordnung mit Plattenelektroden an der Wannenunterseite und Rundelektroden als Fördertrommelauflage (Äquipotentiallinienbild). Die Figur 3 zeigt die Anordnung in der Abwicklung. Ganz links und ganz rechts sind Masseelektroden eingezeichnet, die knapp unterhalb der Oberfläche des Suspensionswassers liegen.

Im Einzugs- und Austragsbereich knapp unter der Wasseroberfläche werden die Stangen durch geerdete Elektroden mit Massepotential verbunden. Auf dem Wannenboden im Elektroporationsbereich sowie an den Wänden im Einzugs- und Austragsbereich sind als Gegenelektroden ebenfalls Stangen oder schmale Platten eingebaut, die im Elektroporationsbereich auf entgegengesetztem Potential bzw. nahe der Wasseroberfläche auf Massepotential liegen.

Die abmessungsbedingt hohen Ströme können von einem einzigen Generator nur mit unvertretbar großem Aufwand geliefert werden. Wegen mit weniger Aufwand durchführbarer Realisierung werden aus diesem Grund mehrere synchron getriggerte Marxgeneratoren parallel das Volumen bepulsen. Um hierbei jitterbedingte Energiependelungen zwischen den Marxgeneratoren zu dämpfen bzw. zu vermeiden, können die Generatoren nicht ohne zusätzlichen Widerstand auf eine Elektrode zusammengeschaltet werden. Statt einer großen Elektrode werden daher mehrere nebeneinanderliegende kleine Teilelektroden eingebaut, die flächig, stab- oder bandförmig sein können oder sonst eine technisch sinnvolle Form/Geometrie haben. Die an die Teilelektroden gleichartig angeschlossenen Marx-Generatoren sind dann nicht direkt, sondern über einen Widerstand parallel geschaltet. In diesem Fall (Fig. 2), wie oben erläutert, fungiert als Widerstand der elektrolytische Widerstand zwischen zwei benachbarten Teilelektroden.

Figur 4 zeigt für den stark gedämpften Betrieb beispielhaft eine Schar gemessener Stromverläufe mit Scheitelwerten zwischen 5 und 7 kA, einer Halbwertsbreite von ca. 1,4 µs und einem leichten Durchschwingen zwischen 0 und ca. 20 %. Die Variation rührt von der unterschiedlichen Prozessgutschüttung her. Entscheidend für die Elektroporation ist die Feldstärke. Scheitelwerte der Feldstärke wurden zwischen 10 kV/cm und 15 kV/cm bei Pulsrepetitionsraten bis zu 8 Hz erzeugt. Dadurch konnten 2 kV/cm Mindestfeldstärke und 4kV/cm im Mittelbereich in einem stark inhomogenen Feld erreicht werden. Puls-Halbwertsbreiten können zwischen 1 µs und ca. 2,5 - 3 µs variieren. Diese beispielhaften Daten wurden bei der Elektroporation von Zuckerrüben aufgenommen. Für anderes biologisch pflanzliches Prozessgut muss eine angepasste, experimentell optimierte Feldstärke angesetzt werden.

Legt man alle Teilelektroden für den gleichen Betriebsstrom aus, zeigt sich, dass die mittleren Elektroden bei gleichem Strom fast doppelt so breit sind wie die randseitigen Elektroden. Dies rührt daher, dass die außen liegenden Elektroden zusätzlich das Randfeld aufbauen müssen. Bei begrenztem Generatorstrom lässt sich also durch den synchronisierten Parallelbetrieb ein größeres Volumen behandeln als bei frei laufenden Marxgeneratoren, bei denen für jede von einem Generator bepulste Elektrodengruppe das Randfeld separat aufgebracht werden muss. Um Randfelder an den seitlichen isolierenden Wänden auszuschließen, werden die Elektroden bis nahe an diese Wände geführt. Randfelder treten somit nur noch am Ein- und Auslass auf. Die Simulationen haben gezeigt, dass ein langer Reaktor, mit möglichst geringem Eingangsquerschnitt energetisch optimal ist. Ist förderungstechnisch eine Mindestbreite vorgegeben, erhält man den kleinstmöglichen Eingangsquerschnitt, indem man die Mindestbreite in beide Richtungen ansetzt.

## Patentansprüche

1. Einrichtung zum Elektroporieren von in eine Prozessflüssigkeit getauchten Früchten, Beeren, Rüben, Wurzeln, dem biologisch pflanzlichen Prozessgut, die aus einem Reaktorraum mit zwei sich darin gegenüberstehenden Elektrodengruppen besteht, die an den Ausgang einer elektrischen, pulsförmig entladbaren Energiequelle angeschlossen sind, um im Reaktorraum zwischen den beiden Elektrodengruppen gepulste elektrische Felder zu erzeugen, die jeweils eine Feldstärke derart erreichen, dass die biologischen Zellen des einem solchen gepulsten elektrischen Feldes mindestens einmal ausgesetzten Prozessguts irreversibel geöffnet, elektroporiert, werden,
**dadurch gekennzeichnet, dass** die Energiequelle elektrisch bipolar aufgebaut ist und aus mindestens einem bipolaren Hochspannungspulsgenerator mit zwei Hochspannungsausgängen besteht, die je eine der beiden Elektrodengruppe kontaktiert, wobei im Falle mehrerer bipolarer Hochspannungspulsgeneratoren dieselben baugleich sind und im Fall von mindestens zwei Hochspannungspulsgeneratoren dieselben jeweils mit einer Triggereinrichtung zum zeitbestimmten gleichzeitigen Zünden versehen sind,
die beiden Elektrodengruppen aus jeweils mindestens einer Teilelektrode bestehen und es somit mindestens ein Teilelektrodenpaar gibt, zwischen dem das zur Elektroporation notwendige gepulste elektrische Feld aufgebaut werden kann, wobei eine Teilelektrode nur an einen und nur einen Hochspannungsausgang angeschlossen ist und der an den Ausgang eines Hochspannüngspulsgenerators angeschlossene Lastkreis in seiner komplexen Impedanz der eines an einen andern Hochspannungspulsgenerators der Energiequelle angeschlossenen Lastkreises gleich ist,
im Falle, dass die Energiequelle aus mindestens zwei Hochspannungspulsgeneratoren besteht, dieselben während der Entladung durch die durch die Prozessflüssigkeit zwischen den Teilelektroden gebildeten elektrolytischen Widerstände voneinander entkoppelt sind.

2. Einrichtung nach Anspruch 1, **dadurch gekennzeichnet, dass** Hochspannungspulsgeneratoren der Energiequelle n-stufige Marx-Generatoren sind, mit n > 1, deren jeweiliger Generatoranfang und jeweiliges Generatorende als die zwei verschiedenen Hochspannungspotentialausgänge zum Anschluss mindestens eines Teilelektrodenpaares aus den beiden Elektrodengruppen herausgeführt sind.

3. Einrichtung nach Anspruch 2, **dadurch gekennzeichnet, dass** die Marx-Generatoren zwischen der ersten und letzten Stufe gleichartig an ein Bezugspotential angeschlossen sind.

4. Einrichtung nach Anspruch 2, **dadurch gekennzeichnet, dass** die Marx-Generatoren an kein Bezugspotential angeschlossen sind, so dass sich das Bezugspotential durch Bezug zur entfernten Masse und Spannungsteilung innerhalb des Prozessguts zwischen den beiden Elektrodengruppen im Reaktorraum selbsttätig einstellt.

5. Einrichtung nach einem der Ansprüche 1 bis 4, **dadurch gekennzeichnet, dass** sich die beiden Elektrodengruppen ortsfest gegenüberstehen.

6. Einrichtung nach einem der Ansprüche 1 bis 4, **dadurch gekennzeichnet, dass** sich die beiden Elektrodengruppen gegeneinander bewegen können.

7. Einrichtung nach Anspruch 2, **dadurch gekennzeichnet, dass**:
der Reaktorraum aus einer Wanne mit zwei sich gegenüberstehenden Wannenwänden besteht, zwischen denen das Prozessgut durchströmt, wobei die eine Wannenwand davon mit einer Gruppe u-förmiger, in Strömungsrichtung aufeinander folgender Teilelektroden und die andere davon ebenfalls mit einer Gruppe gleichartiger Teilelektroden gleicher Anzahl bestückt ist, und zwar derart, dass sich die Teilelektroden bezüglich der Mittenebene zwischen diesen beiden Wänden spiegelbildlich mit offenem U gegenüberstehen und zumindest der innerer Bereich jeden U's blank in der durchströmenden Prozessflüssigkeit liegt,
in der diese beiden Wannenwände verbindenden Wannenwand (Boden) zwei Gruppen an gleichartigen Teilelektroden eingelassen sind,
die stab- oder bandförmig sind und sich bezüglich der Mittenebene spiegelbildlich und fluchtend, ohne sich zu berühren, gegenüberstehen, die in das Wanneninnere exponierten Flächen dieser Elektroden blank in der durchströmenden Prozessflüssigkeit liegen und in Strömungsrichtung in dieser Anordnung aufeinanderfolgen,
die u-förmigen Teilelektroden und die stab- oder bandförmigen Teilelektroden auf der einen Seite der Mittenebene über mindestens einen bipolaren Hochspannungspulsgenerator miteinander verbunden sind, und die u-förmigen Teilelektroden und die stab- oder bandförmigen Teilelektroden auf der andern Seite der Mittenebene gleichartig an einen solchen Hochspannungspulsgenerator angeschlossene sind,
eine leitersprossenartige Anordnung elektrisch leitender Stäbe,
die miteinander elektrisch nichtleitend gekoppelt sind, sich derart mit den jeweiligen beiden Stabenden durch die spiegelbildlich zueinander sitzenden u-förmigen Teilelektroden bewegt, dass die Längsachse der Stäbe stets senkrecht die Mittenebene durchdringen,
die leitersprossenartige Anordnung mit den u-förmigen Elektroden durch den oder die momentan durch ein u-förmiges Elektrodenpaar laufenden Stab oder Stäbe durch das Prozessgut in der Prozessflüssigkeit elektrolytisch gekoppelt ist und die die stab- oder bandförmigen Elektroden ebenso, so dass sich zwischen diesem Stab oder diesen Stäben und den stab- oder bandförmigen Elektroden während der Entladung des elektrischen Energiespeichers das zur Elektroporation notwendige pulsförmige elektrische Feld ausbildet.

8. Einrichtung nach Anspruch 6, **dadurch gekennzeichnet, dass** die leitersprossenartige Stabanordnung zu einer kreisbandförmigen Art zusammen gefasst ist.

9. Einrichtung nach Anspruch 6, **dadurch gekennzeichnet, dass** die leitersprossenartige Stabanordnung in der Art eines über zwei Rollen umlaufenden Bandes zusammengefasst ist.

10. Einrichtung nach einem der Ansprüche 1 bis 9, **dadurch gekennzeichnet, dass**, von der Strömung des Prozessguts her gesehen, vor dem Eintritt in den Bereich der beiden Elektrodengruppen und nach dem Austritt daraus je ein weiteres Elektrodenpaar sitzt, das mit einem Bezugspotential wie Masse verbunden ist.

## Claims

1. Device for the electroporation of fruits, berries, beets, roots - the biologically vegetable processing material - immersed in a process liquid, said device composed of a reactor chamber with two opposing electrode groups therein that are connected to the output of an electric, pulsingly dischargeable energy source in order to generate pulsed electric fields in the reactor chamber between the two electrode groups, said electric fields each reaching a field strength such that the biological cells of the processing material subjected to such a pulsed electric field at least once are irreversibly opened, electroporated,
**characterised in that** the energy source is designed in an electrically bipolar manner and is composed of at least one bipolar high-voltage pulse generator with two high-voltage outputs, said energy source contacting one of the two electrode groups each wherein, in case of several bipolar high-voltage pulse generators, the same have an identical design and, in case of at least two high-voltage pulse generators, the same are each provided with a triggering mechanism used for igniting simultaneously at a specific time,
the two electrode groups each comprise at least one partial electrode and thus there is at least one partial electrode pair between which the pulsed electric field needed for electroporation can be set up, wherein a partial electrode is connected to one and only one high-voltage output and the load circuit connected to the output of a high-voltage pulse generator is identical, regarding its complex impedance, with the load circuit connected to another high-voltage pulse generator of the energy source,
in case the energy source comprises at least two high-voltage pulse generators, the same are disconnected from each other during the discharge by means of the electrolytic resistances formed by the functional fluid between the partial electrodes.

2. Device according to claim 1, **characterised in that** high-voltage pulse generators of the energy source are n-stage Marx generators, with n > 1, whose respective generator beginning and respective generator end are taken as the two different high-voltage potential outputs for the connection of at least one partial electrode pair from the two electrode groups.

3. Device according to claim 2, **characterised in that** the Marx generators are similarly connected to a reference potential between the first and last stages.

4. Device according to claim 2, **characterised in that** the Marx generators are not connected to any reference potential, so that the reference potential automatically sets itself by reference to the removed ground and voltage division within the processing material between the two electrode groups in the reactor chamber.

5. Device according to any one of the claims 1 to 4, **characterised in that** the two electrode groups are stationary opposite each other.

6. Device according to any one of the claims 1 to 4, **characterised in that** the two electrode groups can move against each other.

7. Device according to claim 2, **characterised in that**:
the reactor chamber comprises a trough with two opposing trough walls between which the processing material flows through, wherein the one trough wall thereof is equipped with a group of u-shaped partial electrodes successively arranged in the flow direction and the other one thereof is also equipped with a group of similar partial electrodes equal in number, such that the partial electrodes mirror each other with an open U in respect of the centre plane between these two walls and at least the inner area of each U lies bare in the functional fluid flowing through,
two groups of similar partial electrodes are recessed into the trough wall (bottom) connecting these two trough walls, said electrodes being rod- or ribbon-shaped and, in respect of the centre plane, mirroring and aligned, without touching, the surfaces of these electrodes exposed in the trough interior lying bare in the functional fluid flowing trough and being arranged successively in the flow direction in this arrangement,
the u-shaped partial electrodes and the rod-or ribbon-shaped partial electrodes are connected with each other on the one side of the centre plane by means of at least one bipolar high-voltage pulse generator, and the u-shaped partial electrodes and the rod-or ribbon-shaped partial electrodes are similarly connected to such a high-voltage pulse generator on the other side of the centre plane,
a ladder-rung-like arrangement of electrically conductive rods which are connected in an electrically non-conductive manner, moving with the respective two rod ends by means of the mirrored u-shaped partial electrodes such that the longitudinal axis of the rods always vertically penetrates the centre plane,
the ladder-rung-like arrangement with the u-shaped electrodes is electrolytically connected by means of the one rod or several rods currently running through a u-shaped electrode pair through the processing material in the functional fluid and the rod- or ribbon-shaped electrodes, too, so that, between this rod or these rods and the rod- or ribbon-shaped electrodes, the pulsing electric field required for electroporation forms during discharge of the electric energy store.

8. Device according to claim 6, **characterised in that** the ladder-rung-like rod arrangement is combined into a circular ribbon shape.

9. Device according to claim 6, **characterised in that** the ladder-rung-like rod arrangement is combined into a ribbon revolving over two rollers.

10. Device according to any one of the claims 1 to 9, **characterised in that**, seen from the flow of the processing material, a further electrode pair each is located before the entry into the area of the two electrode groups and after the exit therefrom, said electrode pair being connected with a reference potential such as ground.

## Revendications

1. Dispositif d'électroporation de fruits, baies, raves, racines plongées dans un liquide de procédé, la matière de procédé bio végétale, qui est constitué d'une chambre réactionnelle équipée de deux groupes d'électrodes situés en regard l'un de l'autre qui sont reliés à la sortie d'une source d'énergie électrique pouvant être déchargée sous la forme d'impulsions pour produire dans la chambre réactionnelle, entre les deux groupes d'électrodes, des champs électriques pulsés qui atteignent respectivement une intensité de champ permettant que les cellules biologiques de la matière de procédé, exposées au moins une fois à un tel champ électrique pulsé, ouvertes de façon irréversible, soient électroporées,
**caractérisé en ce que**
la source d'énergie est électriquement bipolaire et est constituée d'au moins un générateur d'impulsions haute tension bipolaire ayant deux sorties haute tension qui sont respectivement en contact avec l'un des deux groupes d'électrodes, dans le cas de plusieurs générateurs d'impulsions haute tension bipolaires, ces générateurs ayant la même construction, et, dans le cas d'au moins deux générateurs d'impulsions haute tension, ces générateurs étant respectivement équipés d'un dispositif de déclenchement de façon à permettre des allumages simultanés à un instant déterminé,
les deux groupes d'électrodes sont respectivement constitués d'au moins une électrode partielle de façon à obtenir au moins une paire d'électrodes partielles entre lesquelles le champ électrique pulsé nécessaire à l'électroporation peut être établi, une électrode partielle n'étant reliée qu'à une même et seule sortie haute tension et l'impédance complexe du circuit de charge relié à la sortie d'un générateur pulsé haute tension étant similaire à l'impédance complexe du circuit de charge relié à l'autre générateur pulsé haute tension de la source d'énergie,
dans le cas où la source d'énergie est constituée d'au moins deux générateurs d'impulsions haute tension, ceux-ci sont découplés l'un de l'autre pendant la décharge par les résistances électrolytiques formées par le fluide de procédé entre les électrodes partielles.

2. Dispositif conforme à la revendication 1,
**caractérisé en ce que**
les générateurs d'impulsions haute tension de la source d'énergie sont des générateurs de Marx à n-étages avec n>1 dont les fronts respectifs et les queues respectives constituent les deux sorties de potentiel haute tension différentes pour la liaison d'au moins une paire d'électrodes partielles des deux groupes d'électrodes.

3. Dispositif conforme à la revendication 2,
**caractérisé en ce qu'**
entre le premier étage et le dernier étage les générateurs de Marx sont reliés de manière similaire à un potentiel de référence.

4. Dispositif conforme à la revendication 2,
**caractérisé en ce que**
les générateurs de Marx ne sont pas reliés à un potentiel de référence de sorte que le potentiel de référence s'établit automatiquement en fonction de la masse située à distance et de la répartition de la tension à l'intérieur de la matière de procédé, entre les deux groupes d'électrodes dans la chambre réactionnelle.

5. Dispositif conforme à l'une des revendications 1 à 4,
**caractérisé en ce que**
les deux groupes d'électrodes sont situés en regard de façon fixe.

6. Dispositif conforme à l'une des revendications 1 à 4,
**caractérisé en ce que**
les deux groupes d'électrodes peuvent se déplacer l'un par rapport à l'autre.

7. Dispositif conforme à la revendication 2,
**caractérisé en ce que**
la chambre réactionnelle est constituée d'une cuve avec deux parois de cuve situés en regard entre lesquelles circule la matière de procédé, l'une de ces parois de cuve étant équipée d'un groupe d'électrodes partielles en forme de U situées à la suite les unes des autres dans la direction de circulation tandis que l'autre paroi de cuve est également équipée d'un groupe d'un même nombre d'électrodes partielles similaires, de de sorte que les électrodes partielles soient inversées et situées en regard par leur U ouvert par rapport au plan médian entre ces deux parois, et qu'au moins la zone interne de chaque évidement de U soit située dans la matière de procédé en circulation,
dans la paroi de la cuve (fond) reliant ces deux parois de cuve sont montés deux groupes d'électrodes partielles similaires qui sont en forme de barres ou de bandes, et sont situées en regard de façon inversée par rapport au plan médian et alignées sans venir en contact, les surfaces exposées dans la partie interne de la cuve de ces électrodes sont situées dans le liquide de procédé en circulation et se suivent dans la direction de circulation, sur l'un des côtés du plan médian les électrodes partielles en forme de U et les électrodes partielles en forme de barres ou de bandes sont reliées par au moins un générateur d'impulsions haute tension bipolaire, tandis que sur l'autre côté du plan médian les électrodes partielles en forme de U et les électrodes partielles en forme de barres ou de bandes sont reliées, de manière similaire à un tel générateur d'impulsions haute tension,
un arrangement en échelons conducteurs de barres électriquement conductrices non reliées de manière électriquement conductrice les unes aux autres se déplace par les deux extrémités des barres respectives au travers des électrodes partielles en forme de U opposées les unes aux autres de sorte que l'axe longitudinal de ces barres traverse toujours perpendiculairement l'axe médian,
l'arrangement en échelons conducteurs est couplé électrolytiquement par la matière de procédé dans le liquide de procédé avec les électrodes en forme de U par la ou les barre(s) se déplaçant momentanément au travers d'une paire d'électrodes en forme de U,
et il en est de même pour les électrodes en forme de barres ou de bandes, de sorte que entre cette barre ou ces barres et les électrodes en forme de barres ou de bandes, se forme, pendant la décharge de l'accumulateur d'énergie électrique le champ électrique pulsé nécessaire à l'électroporation.

8. Dispositif conforme à la revendication 6,
**caractérisé en ce que**
l'arrangement de barres en échelons conducteurs est rassemblée en une bande circulaire.

9. Dispositif conforme à la revendication 6,
**caractérisé en ce que**
l'arrangement de barres en échelons conducteurs est rassemblé sous la forme d'une bande tournant sur deux rouleaux.

10. Dispositif conforme à l'une quelconque des revendications 1 à 9,
**caractérisé en ce que**
dans le sens de la circulation de la matière de procédé, avant l'entrée dans la zone des deux groupes d'électrodes, et après la sortie de cette zone, il est prévu une autre paire d'électrodes respectives qui est reliée à un potentiel de référence tel que la masse.
